Europäisches Patentamt

European Patent Office

Office européen des brevets

(11) Publication number: **0 093 831**

**B1**

# EUROPEAN PATENT SPECIFICATION

(45) Date of publication of patent specification: 03.08.88

(51) Int. Cl.⁴: **H 01 J 27/08**

(21) Application number: **83100688.7**

(22) Date of filing: **26.01.83**

(54) Neutralised low energy ion beam generator, method of producing a neutralised low energy ion beam and method of producing a neutralised high energy ion beam.

(30) Priority: **05.03.82 US 355067**

(43) Date of publication of application:
**16.11.83 Bulletin 83/46**

(45) Publication of the grant of the patent:
**03.08.88 Bulletin 88/31**

(84) Designated Contracting States:
**DE FR GB**

(56) References cited:
**US-A-3 308 621**
**US-A-3 387 176**
**US-A-3 515 932**
**US-A-3 523 210**
**US-A-3 956 666**

(73) Proprietor: **International Business Machines Corporation**
**Old Orchard Road**
**Armonk, N.Y. 10504 (US)**

(73) Proprietor: **Kaufman, Harold Richard**
**401, Spinnaker**
**Fort Collins Colorado 80525 (US)**

(72) Inventor: **Harper, James McKell Edwin**
**407 Elisabeth Road**
**Yorktown Heights New York 10598 (US)**
Inventor: **Heiblum, Mordehai**
**2375 Mark Road**
**Yorktown Heights New York 10598 (US)**
Inventor: **Kaufman, Harold Richard**
**401 Spinnaker**
**Fort Collins Colorado 80525 (US)**

(74) Representative: **Carpmael, John William Maurice et al**
**CARPMAELS & RANSFORD 43 Bloomsbury Square**
**London, WC1A 2RA (GB)**

Courier Press, Leamington Spa, England.

# Description

The present invention relates to the generation of neutralised ion beams and more particularly to a neutralized low energy ion beam generator, a method of producing a neutralised low energy ion beam and a method of producing a neutralised high energy ion beam.

Sputtering techniques for precisely machining the surface of a target substrate are well known. These techniques require the generation of an ion beam at an energy level sufficient to remove atomic particles from a target surface of the substrate by bombardment with the ion beam. The sputtered particles may themselves be deposited through suitable masking onto a second substrate to form a precise deposition layer for an electronic component.

The efficiency of sputtering systems of the prior art is limited when bombarding substrates which are insulators because of an electric charge which develops on the surface of the target area. The charge can be reduced by adding to the incident ion beam free electrons, in the case of a positive ion sputtering beam, or positive ions in the case of a negative ions sputtering beam.

In the case of a positive ion beam, free electrons have been added to the positive ion beam by means of a separate emitter, in the path of the ion beam, usually a filament carrying an electrical current. This technique of neutralising the beam adds free electrons to the ion beam, neutralising the charge at the substrate surface.

Several disadvantages are encountered when using the filament neutralising technique, the first of which is contamination of the substrate. It is not unusual for the filament to evaporate or sublime whereby contaminant are added to the ion beam.

Placing the filament in the ion beam also causes the substrate to be heated which, in the case of some substrates, causes degradation of the substrate surface. Additionally, the filament is subject to bombardment by the incident ion beam thereby sputtering filament particles into the ion beam which end up on the substrate.

One prior art technique of producing a neutralised ion beam is described in US Patents 3,523,210 and 3,515,932. This neutraliser requires that a certain beam current level be established to maintain a bridge of plasma for adding neutralising electrons to the ion stream. Thus, neutralisation is dependent on a current intensity sufficient to form a plasma bridge wherein a portion of the plasma exits the plasma generator to enter the ion stream. Low current ion beam production cannot therefore make use of this technique because of the current requirements necessary with plasma bridge neutralisation. The plasma bridge neutralisation technique generates a plume of ions and electrons resulting in a poorly directed beam incapable of being aimed at a distant target.

The present invention seeks to provide solutions to the problem of generating neutralised ion beams which do not suffer from the disadvantages of being contaminated and/or causing excessive heating of a substrate target.

According to the present invention, this is provided a neutralised low energy ion beam generator comprising a chamber containing an anode and a cathode, means to introduce an ionisable gas into the chamber, and means for providing a potential difference between the cathode and the anode to form a plasma; containing positive ions, high energy primary electrons and the low energy background electrons the generator being characterised in that one wall of the chamber is in the form of a grid disposed to one side of a direct path between the anode and the cathode and means is provided for maintaining the grid at a potential slightly more positive than the cathode, whereby ions and high energy primary electrons from the plasma flow through the grid to thereby produce a neutralised low energy ion beam.

Preferably, in the present generator, the cathode is disposed at such a position in the chamber to minimize contamination of the neutralised low energy ion beam.

The present invention also provides a method of operating the generator of the present invention comprising: passing an electrical current between the anode and the cathode in the gas filled chamber to produce a plasma containing positive ions, high energy primary electrons and low energy background electrons, the method being characterised by establishing such a potential on the grid disposed to one side of the plasma that positive ions and high energy primary electrons from the plasma flow through the grid thereby producing a neutralised low energy ion beam.

Preferably, the grid is maintained at a potential of from 1 to 5 volts positive with respect to the cathode.

The present invention also provides a method of producing a neutralised high energy ion beam by directing across an unneutralised high energy ion beam a neutralised relatively low energy beam containing charged particles of opposite polarity to that of the ions in the unneutralised high energy ion beam, characterised in that the neutralised relatively low energy beam is produced by the generator or by the method of the present invention.

The ions in the unneutralised high energy beam may be of negative polarity, in which case the low energy beam contains positive ions, or they may be of positive polarity, in which case the low energy beam contains free electrons. How the invention can be carried out will now be described by way of example, with reference to the accompanying drawings, in which:—

Figure 1 represents a generator embodying the invention, for providing a self-neutralised low energy ion beam;

Figure 2 indicates the potential distribution in the generator of Figure 1,

Figure 3 indicates the energy distribution of electrons in the chamber in the generation of Figure 1, and

Figure 4 represents a system for producing a neutralised high energy ion beam.

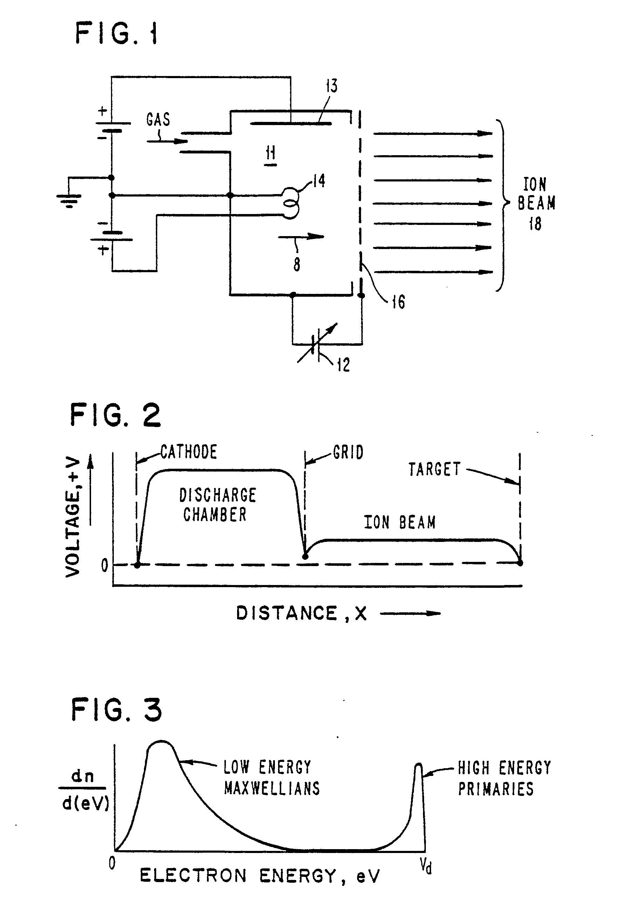

A neutralised low energy ion beam generator (Figure 1) comprises a chamber 11 for receiving a gas to be ionised. The gas may be, for example, argon with a chamber pressure of 0.133 Pa (1 mTorr). A magnetic field 8 is established across the chamber 11 to increase its ion producing efficiency.

A filament 14 is connected to a source of electric potential and thereby emits electrons. An anode 13 is maintained at a potential for attracting the electrons.

The migrating electrons have an energy level distribution as shown in Figure 3. The first major electron population has a low energy Maxwellian distribution. The second major electron population comprises a group of high energy primary electrons. The electrons which migrate within the chamber 11 collide with gas atoms producing both positive ions and low energy electrons. A plasma forms having a potential several volts positive of the anode.

A grid 16 having a plurality of apertures is maintained at a potential for accelerating the positive ions in the plasma through the apertures to the exterior of the chamber 11. A sheath forms between the plasma and grid as a boundary for the plasma due to the potential on the grid 16.

The generator of Figure 1 is capable of supplying to the positive ion beam negative electrons for neutralising the beam. To make use of the electrons within the plasma as neutralising particles, the grid 16 is maintained at a potential slightly positive of the cathode 14 within the chamber 11. The potential distribution within the chamber 11 for this condition is shown in Figure 2. The cathode 14 potential is established to be zero volts. The anode is held at a voltage of 40 volts positive of the cathode. The plasma assumes a positive potential with respect to the cathode, and a voltage gradient exists between the plasma, cathode 14 and grid 16 forming a sheath for the plasma.

The single grid 16 is maintained at a slightly positive voltage, typically 1—5 volts, with respect to the cathode 14. The advantage of maintaining a potential distribution within the chamber 11 as shown in Figure 2 is the introduction of free electrons into the positive ion beam 18 formed at screen grid 16. The positive voltage on the single grid 16 permits high energy primary electrons (Figure 3) to migrate towards the grid. These primary electrons balance the charge provided by the ions exiting the grid 16.

The high energy primary electrons in the plasma which exit through grid 16 have dissipated much of their kinetic energy in passing over the grid 16 and have an energy level desirable for neutralisation.

The grid 16 potential is maintained at a desirable level for promoting a positive ion, self neutralised beam by either allowing the grid to float and assume a potential established by the collision of electrons and ions on the grid, or by using a power supply 12 connected between the grid 16 and the chamber 11 as shown in Figure 1.

To further reduce the possible contamination of the generated ion stream, the cathode 14 is located at a position within the chamber 11 so that no line of sight path exists between the target irradiated with the ion beam and the cathode 14. This apparatus for generating a self neutralised beam is particularly useful in low energy ion beam formation having an energy of less than 100 ev.

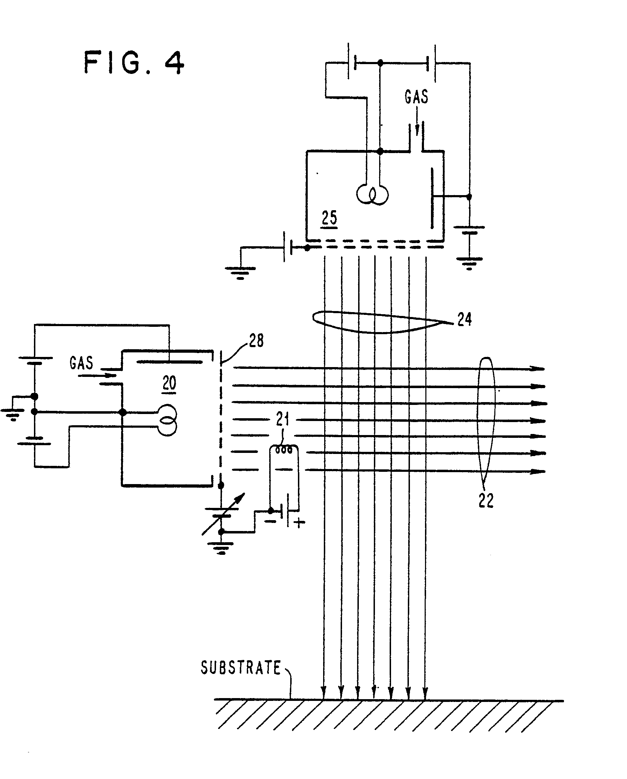

The ion source of Figure 1, being self neutralised, is useful for neutralising other, higher intensity ion beams as will be described with reference to Figure 4. More generally, a sputtering beam is neutralised by a secondary low energy ion beam which intersects the sputtering beam. The secondary beam contains particles having the appropriate charge for neutralising the sputtering beam, positive ions in the case of a negative ion sputtering beam, and free electrons in the case of a positive ion sputtering beam. The low energy beam provides for minimum interaction with the sputtering beam and surrounding vacuum facility.

Referring now to Figure 4, a secondary, low energy beam 22 is directed towards a primary sputtering beam 24. The arrangement of Figure 4 is useful for neutralising both positive ion beams and negative ion beams. The primary sputtering beam is generated by a multi-grid, high energy ion accelerator 25.

The arrangement of Figure 4 does not require the particular ion source of Figure 1 to generate the secondary beam. The use of a refractory metal filament 21 external to the ion source 20 will provide free electrons which will neutralise both the secondary and primary ion beams 22, 24 generated by ion sources 20 and 25. The filament 21 can be located at least 10 cm from the main beam so that heating of the substrate can be minimized. In either type of secondary low energy beam generation, self-neutralised or externally neutralised, the single grid 28 ion source is contemplated for providing an adequate secondary ion beam. The single grid accelerator is used also in those applications where a positive ion beam neutralises a negative ion beam. In a negative ion beam, positive ions from a secondary beam eventually appear as randomised thermal energy.

The neutralisation capability of this secondary ion beam is demonstrated considering the following example. Assuming that a secondary, 30 ev argon beam of positive ions is used to carry electrons for neutralising both beams, having a radius of 1 cm and a current density of 1 mA/cm², the ion velocity can be determined as:

$$V_1 = 1.389 \times 10^4 [E(ev)/M_i(amu)]^{\frac{1}{2}}$$
$$= 1.389 \times 10^4 [30/40]^{\frac{1}{2}}$$
$$= 1.20 \times 10^4 \text{ m/s}$$

The ion and electron density is

$$n = J^i/q \, V_1 = 10/1.602 \times 10^{-19} \times 1.20 \times 10^4$$
$$= 5.2 \times 10^{15} \text{ m}^{-3},$$

where $J^i$ is the current density, and q is the charge of an electron. The saturation electron current through the beam is calculated as follows.

$$J^s = nqvA/4,$$

where

A = beam cross sectional area, and
v = beam electron velocity.

For an average neutraliser, the electron temperature would be expected to be 1—2ev, producing mean electron velocities of $6.69 \times 10^5$ m/s to $9.46 \times 10^5$ m/s. This produces a saturation current $J^s$ of between 44 mA and 62 mA when applied as above.

Thus, the 30 ev argon beam is capable of producing a saturation electron current within 44—62 mA. The electron current can in accordance with the above calculation be increased with a higher electron temperature or by increasing the cross section area of the beam.

The potential drop across the secondary beam over a 10 cm length should not significantly affect the electron current capacity of the second beam. Considering a typical plasma resistivity for electron energies of 1—2 ev, the resistance of a 10 cm length of the secondary beam should be between .20 ohms and .08 ohms thereby providing a voltage drop of 9 mv and 5 mv respectively. This should only minimally affect the electron current carrying capability of the beam.

## Claims

1. A neutralised low energy ion beam generator comprising a chamber (11) containing an anode (13) and a cathode (14), means to introduce an ionisable gas into the chamber (11), and means for providing a potential difference between the cathode (14) and the anode (13) to form a plasma containing positive ions, high energy primary electrons and low energy background electrons; the generator being characterised in that one wall of the chamber is in the form of a grid (16) disposed to one side of a direct path between the anode (13) and the cathode (14) and means (12) is provided for maintaining the grid (16) at a potential slightly more positive than the cathode (14), whereby ions and high energy primary electrons from the plasma flow through the grid (16) to thereby produce a neutralised low energy ion beam (18).

2. The neutralised low energy ion beam generator of claim 1, in which the cathode (14) is disposed at such a position in the chamber (11) to minimize contamination of the neutralised low energy ion beam (18).

3. A method of operating the neutralised low energy ion beam generator of claim 1 or claim 2 comprising: passing an electrical current between the anode (13) and the cathode (14) in the gas filled chamber (11) to produce a plasma containing positive ions, high energy primary electrons and low energy background electrons, the method being characterised by establishing such a potential on the grid (16) disposed to one side of the plasma that positive ions and high energy primary electrons from the plasma flow through the grid (16) thereby producing a neutralised low energy ion beam (18).

4. The method of claim 3, in which the grid (16) is maintained at a potential of from 1 to 5 volts positive with respect to the cathode (14).

5. A method of producing a neutralised high energy ion beam by directing across an unneutralised high energy ion beam (24) a neutralised relatively low energy beam (22) containing charged particles of opposite polarity to that of the ions in the unneutralised high energy ion beam (24), characterised in that the neutralised relatively low energy beam (22) is produced by the generator of claim 1 or claim 2 or by the method of claim 3 or claim 4.

6. The method of claim 5, in which the ions in the unneutralised high energy beam (24) are of negative polarity and the low energy beam (22) contains positive ions.

7. The method of claim 5, in which the ions in the unneutralised high energy beam (24) are of positive polarity and the low energy beam (22) contains free electrons.

## Patentansprüche

1. Ionenstrahlgenerator zur Erzeugung eines neutralisierten Niederenergie-Ionenstrahls mit einer Kammer (11), welche eine Anode (13) und eine Kathode (14) enthält, Mitteln zum Einführen eines ionisierbaren Gases in die Kammer (11), und Mitteln zur Schaffung einer Potentialdifferenz zwischen der Kathode (14) und der Anode (13) zur Ausbildung eines Plasmas, welches positive Ionen, hochenergetische Primärelektronen und niederenergetische Untergrundelektronen enthält, wobei der Generator dadurch gekennzeichnet ist, daß eine Wand der Kammer in Form eines Gitters (16) vorliegt, das an einer Seite eines direkten Weges zwischen der Anode (13) und der Kathode (14) angeordnet ist, und Mittel (12) zum Halten des Gitters (16) auf einem Potential, das geringfügig positiver als die Kathode (14) ist, vorgesehen sind, wodurch Ionen und hochenergetische Primärelektronen aus dem Plasma durch das Gitter (16) strömen und so einen neutralisierten Niederenergie-Ionenstrahl (18) hervorbringen.

2. Ionenstrahlgenerator zur Erzeugung eines neutralisierten Niederenergie-Ionenstrahls nach Anspruch 1, bei welchem die Kathode (14) an einer solchem Stelle in der Kammer (11) angeordnet ist, daß eine Kontamination des neutralisierten Niederenergie-Ionenstrahls (18) minimalisiert ist.

3. Verfahren zur Betreibung des Ionenstrahlgenerators zur Erzeugung eines neutralisierten Niederenergie-Ionenstrahls nach Anspruch 1 oder 2, welches das Führen eines elektrischen Stromes zwischen der Anode (13) und der Kathode (14) in der gasgefüllten Kammer (11) zur Erzeugung eines positiven Ionen, hochenergetische Primärelektronen und niederenergetische Untergrundelektronen enthaltenden Plasmas umfaßt, wobei das Verfahren gekennzeichnet ist durch die Erzeugung eines solchen Potentials auf dem an der einen Seite des Plasmas angeordneten Gitter (16), daß positive Ionen und hochenergetische Primärelektronen aus dem Plasma durch das Gitter (16) strömen und dadurch einen neutralisierten Niederengergie-Ionenstrahl (18) hervorbringen.

4. Verfahren nach Anspruch 3, bei welchem das Gitter (16) auf einem Potential von 1 bis 5 Volt positiv in Bezug auf die Kathode (14) gehalten wird.

5. Verfahren zur Erzeugung eines neutralisierten Hochenergie-Ionenstrahls, indem quer durch einen unneutralisierten Hochenergie-Ionenstrahl (24) ein geladene Teilchen entgegengesetzter Polarität wie die der Ionen im unneutralisierten Hochenergie-Ionenstrahl (24) enthaltender neutralisierter Strahl (22) verhältnismäßig niedriger Energie gerichtet wird, dadurch gekennzeichnet, daß der neutralisierte Strahl (22) verhältnismäßig niedriger Energie durch den Generator nach Anspruch 1 oder 2 oder durch das Verfahren der Ansprüche 3 oder 4 erzeugt wird.

6. Verfahren nach Anspruch 5, bei welchem die Ionen in dem unneutralisierten Hochenergie-Strahl (24) negative Polarität haben und der Niederenergie-Strahl (22) positive Ionen enthält.

7. Verfahren nach Anspruch 5, bei welchem die Ionen im unneutralisierten Hochenergie-Strahl (24) positive Polarität haben und der Niederenergie-Strahl (22) freie Elektronen enthält.

**Revendications**

1. Un générateur de faisceau d'ions neutralisé à faible énergie, comprenant une chambre (11) contenant une anode (13) et une cathode (14), des moyens pour introduire un gaz ionisable dans la chambre (11) et des moyens pour produire une différence de potentiel entre la cathode (14) et l'anode (13) pour former un plasma contenant des ions positifs, des électrons primaires à haute énergie et des électrons secondaires de faible énergie, générateur caractérisé en ce qu'une paroi de la chambre est formée par une grille (16) disposée d'un côté d'un trajet direct allant de l'anode (13) à la cathode (14), et en ce qu'il est prévu des moyens (12) pour maintenir la grille (16) à un potentiel légèrement plus positif que celui de la cathode (14), de manière que des ions et des électrons primaires à haute énergie provenant du plasma puissent traverser la grille (16) afin de produire un faisceau d'ions neutralisé à faible énergie (18).

2. Le générateur de faisceau d'ions neutralisé à faible énergie de la revendication 1, dans lequel la cathode (14) est disposée dans la chambre (11) à un endroit qui permette de minimiser la contamination du faisceau d'ions neutralisé à faible énergie (18).

3. Un procédé de mise en oeuvre du générateur de faisceau d'ions neutralisé à faible énergie de l'une des revendications 1 et 2, dans lequel on fait passer un courant électrique entre l'anode (13) et la cathode (14) dans la chambre (11) remplie de gaz afin de produire un plasma contenant des ions positifs, des électrons primaires à haute énergie et des électrons secondaires à faible énergie, procédé caractérisé en ce qu'on établit sur la grille (16) disposée sur l'un des côtés du plasma un potentiel tel que les ions positifs et les électrons primaires à haute énergie provenant du plasma passent au travers de la grille (16), afin de produire un faisceau d'ions neutralisé à faible énergie (18).

4. Le procédé la revendication 3, dans lequel on maintient la grille (16) à un potentiel compris entre 1 et 5 volts, positivement par rapport à la cathode (14).

5. Un procédé pour produire un faisceau d'ions neutralisé à haute énergie en faisant croiser un faisceau d'ions non neutralisé à haute énergie (24) par un faisceau d'ions neutralisé à relativement faible énergie (22) contenant des particules chargées de polarité opposée à celle des ions du faisceau d'ions non neutralisé à haute énergie (24), caractérisé en ce que le faisceau d'ions neutralisé à relativement faible énergie (22) est produit par le générateur de l'une des revendications 1 et 2, ou par le procédé de l'une des revendications 3 ou 4.

6. Le procédé de la revendication 5, dans lequel les ions du faisceau d'ions non neutralisé à haute énergie (24) sont de polarité négative et le faisceau d'ions à faible énergie (22) contient des ions positifs.

7. Le procédé de la revendication 5, dans lequel les ions du faisceau non neutralisé à haute énergie (24) sont de polarité positive et le faisceau d'ions à faible énergie (22) contient des électrons libres.

FIG. 1

GAS

13

11

14

8

ION
BEAM
18

16

12

FIG. 2

CATHODE

GRID

TARGET

VOLTAGE, +V

DISCHARGE
CHAMBER

ION BEAM

0

DISTANCE, X

FIG. 3

$\dfrac{dn}{d(eV)}$

LOW ENERGY
MAXWELLIANS

HIGH ENERGY
PRIMARIES

0

$V_d$

ELECTRON ENERGY, eV

1

# FIG. 4

SUBSTRATE